(19) Europäisches Patentamt
European Patent Office
Office européen des brevets

(11) **EP 2 397 863 B1**

(12) **FASCICULE DE BREVET EUROPEEN**

(45) Date de publication et mention
de la délivrance du brevet:
**12.12.2012 Bulletin 2012/50**

(51) Int Cl.:
***G01R 31/36*** *(2006.01)*

(21) Numéro de dépôt: **11168849.5**

(22) Date de dépôt: **06.06.2011**

(54) **Systeme de surveillance de l'etat d'une batterie**

Verfahren zur Überwachung des Zustands einer Batterie

System for monitoring the status of a battery

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.06.2010 FR 1054707**

(43) Date de publication de la demande:
**21.12.2011 Bulletin 2011/51**

(73) Titulaire: **SAFT**
**93170 Bagnolet (FR)**

(72) Inventeurs:
• **Benjamin, Sébastien**
**33850 Leognan (FR)**
• **Desprez, Philippe**
**33320 Le Taillan Medoc (FR)**
• **Barrailh, Gérard**
**33170 Gradignan (FR)**
• **Laflaquiere, Philippe**
**33800 Bordeaux (FR)**

(74) Mandataire: **Hirsch & Associés**
**58, avenue Marceau**
**75008 Paris (FR)**

(56) Documents cités:
**JP-A- 2000 150 002     JP-A- 2009 037 962**
**US-A- 5 675 258        US-A- 6 094 031**
**US-A1- 2003 030 442**

**Description**

La présente invention se rapporte à un système de surveillance pour batterie permettant d'indiquer s'il faut remplacer ou non la batterie.

Un générateur électrochimique ou accumulateur (ces deux termes sont équivalents) est un dispositif de production d'électricité dans lequel de l'énergie chimique est convertie en énergie électrique. L'énergie chimique est constituée par des composés électrochimiquement actifs déposés sur au moins une face d'électrodes disposées dans l'accumulateur. L'énergie électrique est produite par des réactions électrochimiques au cours d'une décharge de l'accumulateur. Les électrodes, disposées dans un conteneur, sont connectées électriquement à des bornes de sortie de courant qui assurent une continuité électrique entre les électrodes et un consommateur électrique auquel l'accumulateur est associé.

Typiquement une batterie comprend une pluralité d'accumulateurs appelés aussi générateurs électrochimiques, cellules ou éléments. Une batterie peut être divisée en modules, chaque module étant composé d'une pluralité d'accumulateurs reliés entre eux en série et/ou en parallèle. Ainsi la batterie peut comporter une ou plusieurs branches parallèles d'accumulateurs reliés en série. La batterie est destinée à fournir de l'énergie électrique à une application extérieure. Un circuit de charge est généralement prévu auquel la batterie peut être branchée pour recharger les accumulateurs. Un système de gestion comprenant des capteurs de mesures et un circuit électronique de contrôle, plus ou moins évolué selon les applications, peut être associé à la batterie.

Dans une batterie, le courant d'autodécharge peut varier d'un accumulateur à l'autre. L'état de charge peut ainsi ne pas être uniforme pour tous les accumulateurs de la batterie. Ce problème d'équilibrage de l'état de charge entre accumulateurs d'une batterie est bien connu. Un système électronique peut alors être utilisé pour équilibrer l'état de charge des différents accumulateurs les uns par rapport aux autres.

L'état de charge (SOC pour State of Charge en anglais) et l'état de santé (SOH pour State of Health en anglais) sont des informations utiles au système électronique de gestion de la batterie pour optimiser son utilisation et sa durée de vie.

Typiquement, l'état de charge SOC est déterminé comme la quantité d'énergie disponible dans la batterie rapportée à l'énergie d'une batterie totalement chargée. L'état de charge SOC peut être calculé par exemple selon un algorithme utilisant des mesures de tension, ou l'intégration du courant de charge/décharge en fonction du temps.

L'état de santé SOH de la batterie permet d'estimer le vieillissement de la batterie entre un état neuf et un état fin de vie. Le SOH peut être calculé selon l'application à partir du rapport de l'impédance de la batterie à un instant donné sur l'impédance de la batterie à l'état neuf à même température. Le SOH peut également être calculé à partir du rapport de la capacité de la batterie à un instant donné sur la capacité de la batterie à l'état neuf à même température. Un tel algorithme de SOH est dit dynamique.

Selon la taille de la batterie, le SOH peut être calculé au niveau batterie, au niveau module ou au niveau accumulateur. Sur des batteries comportant de nombreux accumulateurs, une estimation du SOH au niveau de chaque accumulateur est contraignante et impose un surcoût au niveau des circuits électroniques. En effet le nombre important de calculs à réaliser engendre des contraintes de puissance de calcul sur l'unité de traitement du circuit électronique de contrôle.

Une autre méthode de détermination du SOH d'une batterie consiste à surveiller les valeurs de température, de tension, et éventuellement de courant de la batterie afin de déterminer une valeur de SOH à partir de lois de vieillissement. Ces lois de vieillissement sont obtenues à partir d'essais réalisés en laboratoire. Cet algorithme de SOH dit statique donne alors une estimation du vieillissement de la batterie. Cependant ce mode de détermination du SOH de la batterie est soumis à l'hypothèse d'un vieillissement homogène des accumulateurs de la batterie. Le mode de détermination du SOH par un modèle prédictif suppose également un circuit de puissance sans défaillance entre les accumulateurs.

Ainsi, la plupart des batteries intègrent un système de gestion offrant les services d'estimation de l'état de charge des accumulateurs, d'estimation de leur état de santé, et d'équilibrage de leur état de charge, afin d'optimiser l'utilisation de la batterie.

De plus, la plupart des systèmes de gestion pour batterie intègrent des systèmes de surveillance afin de se prémunir d'un ou de plusieurs événements pouvant aboutir à une utilisation abusive de la batterie. Une utilisation abusive peut provoquer un événement redouté tel qu'un feu. Ainsi, le système de surveillance peut détecter si les tensions des accumulateurs, des modules, ou de la batterie sont supérieures à un seuil maximum. Le système de surveillance peut également détecter si les tensions des accumulateurs, des modules, ou de la batterie sont inférieures à un seuil minimum. Le système de surveillance peut aussi détecter si la température de la batterie est supérieure à un seuil maximum, ou si la température de la batterie devient inférieure à un seuil minimum.

Cependant, les systèmes de surveillance précédemment décrits ne permettent pas de prévenir un utilisateur en cas de défaillance prématurée de la batterie pouvant entraîner un évènement nécessitant le remplacement de la batterie.

Par exemple, une défaillance peut être une perte de la capacité de la batterie, qui peut s'accompagner des évènements redoutés tels qu'un risque de tension élevée au niveau accumulateur et un échauffement de la batterie. Une perte de la capacité de la batterie peut être causée par une défaillance du circuit d'équilibrage.

Une autre défaillance peut être une dispersion importante entre les résistances des accumulateurs (ici, la résistance d'un accumulateur comprend également la résistance de connectique entre le circuit de puissance et les bornes de puissance de l'accumulateur). Ceci peut entraîner des événements redoutés tels qu'un point chaud local, et une énergie disponible non garantie due à une chute ohmique trop élevée par rapport à un vieillissement normal de la batterie.

Une autre défaillance peut être la mise en circuit ouvert d'un accumulateur lorsqu'un ou plusieurs accumulateurs sont connectés en parallèles. Dans ce cas, un événement redouté peut être une énergie disponible non garantie. Un autre événement redouté peut être un courant trop important traversant les accumulateurs situés sur les branches non défaillantes. Ceci peut conduire à un problème de sécurité si les branches d'accumulateurs non défaillants ne sont pas dimensionnées pour passer ce surplus de courant ; et si les branches d'accumulateurs non défaillants sont dimensionnées pour permettre le passage de ce surplus de courant, cela engendre une perte d'énergie massique de la batterie.

Dans les systèmes de gestion classiques, seule une estimation de l'impédance dynamique au niveau accumulateur permet de détecter le problème de dispersion de résistance. Il faut pour cela utiliser un algorithme de SOH dynamique, par exemple de type filtre étendu de Kalman comme décrit dans le document US-A-7 315 789 par exemple ; mais en contrepartie, un surdimensionnement de l'unité de traitement du circuit électronique de contrôle est nécessaire. De plus, ce type d'algorithme ne détecte pas un dysfonctionnement du système d'équilibrage car il n'estime que les paramètres des accumulateurs électrochimiques et n'opère donc pas sur le système batterie dans son ensemble.

Les documents JP-A-2000150002, JP-A-2002334726, JP-A-2003257504, ou encore JP2009037962 proposent des systèmes de détection de défaillance pour batterie à partir de tensions mesurées aux bornes des accumulateurs de la batterie. Cependant, les systèmes présentés dans ces documents détectent uniquement une surdécharge d'un accumulateur de la batterie, mais ne permettent pas de détecter une dispersion entre les résistances des accumulateurs, une perte de la capacité de la batterie, ou une défaillance d'un accumulateur en circuit ouvert.

US 5 675 258 décrit une méthode de détection de la détérioration d'un pack de batteries comprenant une association en série d'une pluralité de modules, laquelle méthode détecte une différence de tension entre la pluralité de modules de batterie pendant la charge, une détection de détérioration étant inhibée jusqu'à ce qu'une capacité prédéterminée soit chargée après le début de la charge. Par conséquent, les dispersions de tension au stade initial de la charge causées par des différences de profondeur de décharge entre des éléments électrochimiques ne sont pas détectées de manière erronée comme étant une détérioration du pack de batteries.

Il est donc recherché un système électronique pour batterie permettant de détecter les défaillances décrites précédemment.

A cette fin, la présente invention propose un système de surveillance pour batterie ayant une pluralité d'accumulateurs, le système comprenant :

- des moyens de mesure de la tension aux bornes de chaque accumulateur ;
- des moyens de mesure de la température de la batterie ;
- des moyens de mesure du courant traversant la batterie ;
- des moyens de calcul d'une différence de tension entre une tension maximale mesurée aux bornes d'un des accumulateurs et une tension minimale mesurée aux bornes d'un des accumulateurs ;
- des moyens de comparaison de la différence de tension avec au moins une valeur seuil dépendant de la température et du courant mesurés; et
- des moyens signalant une erreur si la différence de tension est supérieure ou égale à l'au moins une valeur seuil.

Selon une variante, au moins l'un des moyens de signalisation d'erreur est désactivé si la valeur absolue du courant mesuré sort d'une plage de valeurs seuils de courant, la plage de valeurs étant spécifique à la valeur seuil.

Selon une variante, la différence de tension est comparée à une valeur seuil $\Delta Vs1$ définie comme

$$\Delta Vs1 = n \times R(T) \times \frac{Ibat}{p-1},$$

où $p$ est le nombre de branches parallèles d'accumulateurs de la batterie, avec $p \geq 2$, et $n$ est le nombre d'accumulateurs reliés en série dans chaque branche,
$R(T)$ est la résistance en début de vie des accumulateurs électrochimiques constituant la batterie - qui dépend de la température, et

Ibat est le courant traversant la batterie.

Selon une variante, la différence de tension est comparée à une valeur seuil ΔVs2 définie comme

$$\Delta Vs2 = \Delta R_{max}(T) \times \frac{Ibat}{p},$$

où p est le nombre de branches parallèles d'accumulateurs de la batterie,
$\Delta R_{max}(T)$ est la dispersion maximale tolérée entre les résistances internes des accumulateurs - qui dépend de la température, et
Ibat est le courant traversant la batterie.

Selon une variante, le système de surveillance est pour une batterie ayant des accumulateurs assemblés en une pluralité de branches parallèles, le système comprenant en outre :

- des moyens de mesure du courant traversant chaque branche de la batterie;
- des moyens de comparaison du courant de chaque branche avec un premier seuil et avec un deuxième seuil ;
- des moyens signalant une erreur si pour une des branches de la batterie le courant mesuré est inférieur ou égal au premier seuil et si pour une autre des branches de la batterie le courant mesuré est supérieur ou égal au deuxième seuil.

Selon une variante, la différence de tension est comparée à une valeur seuil prédéterminée lorsque le courant de la batterie est sensiblement nul.

L'invention concerne également un système de supervision pour batterie comprenant :

- un système de surveillance selon l'invention, et
- un moyen de détermination de l'état de charge (SOC) de la batterie.

Selon une variante, le système de supervision pour batterie comprend:

- des moyens de détermination de l'état de charge (SOC) de chaque accumulateur de la batterie,
- des moyens de détermination de la dispersion d'état de charge des accumulateurs,

ladite au moins une valeur seuil étant corrigée si la dispersion d'état de charge est supérieure à une valeur prédéterminée.

L'invention concerne également un système de supervision pour batterie comprenant :

- un système de surveillance selon l'invention,
- un moyen de détermination de l'état de santé (SOH) de la batterie à partir d'un modèle prédictif,

dans lequel, si la différence de tension est supérieure à au moins une valeur seuil, les moyens de signalisation d'erreur indiquent que le modèle prédictif de détermination du SOH est invalide.

L'invention concerne également un système de supervision pour batterie comprenant :

- un système de surveillance selon l'invention, et
- un système d'équilibrage de la charge des accumulateurs de la batterie.

L'invention concerne également un système de supervision pour batterie selon l'invention dans lequel les moyens de signalisation d'erreur du système de surveillance permettent de prévenir un utilisateur.

D'autres caractéristiques et avantages de l'invention apparaîtront à la lecture de la description qui suit, donnée à titre d'exemple et en référence aux figures qui montrent :

- Figure 1, un schéma explicatif du système de surveillance selon l'invention et de son utilisation;
- Figure 2, un exemple de batterie utilisant le système de supervision selon l'invention ;
- Figure 3, des graphes montrant le comportement attendu de la batterie présentée en figure 2 lorsqu'elle ne présente pas de dispersion de résistance, d'accumulateurs en circuit ouvert, ni une perte de capacité élevée;
- Figure 4, des graphes montrant la détection d'un accumulateur en circuit ouvert parmi les accumulateurs de la batterie présentée en figure 2 ;
- Figure 5, des graphes montrant la détection d'une dispersion de résistance importante entre les accumulateurs de la batterie présentée en figure 2 ;

- Figure 6, des graphes montrant la détection d'une perte de capacité élevée dans une batterie.

L'invention concerne un système de surveillance pour batterie ayant une pluralité d'accumulateurs. Le système de surveillance de l'invention permet de détecter une défaillance prématurée de la batterie, c'est-à-dire une défaillance ne relevant pas d'un vieillissement prévisible de la batterie. Ainsi, le système de surveillance permet de détecter une perte de la capacité de la batterie, une dispersion élevée entre les résistances des accumulateurs, et une mise en circuit ouvert d'un accumulateur. L'indication de la détection de l'une des trois défaillances mentionnées ci-dessus sera appelée par la suite SOF (SOF pour State Of Failure en anglais).

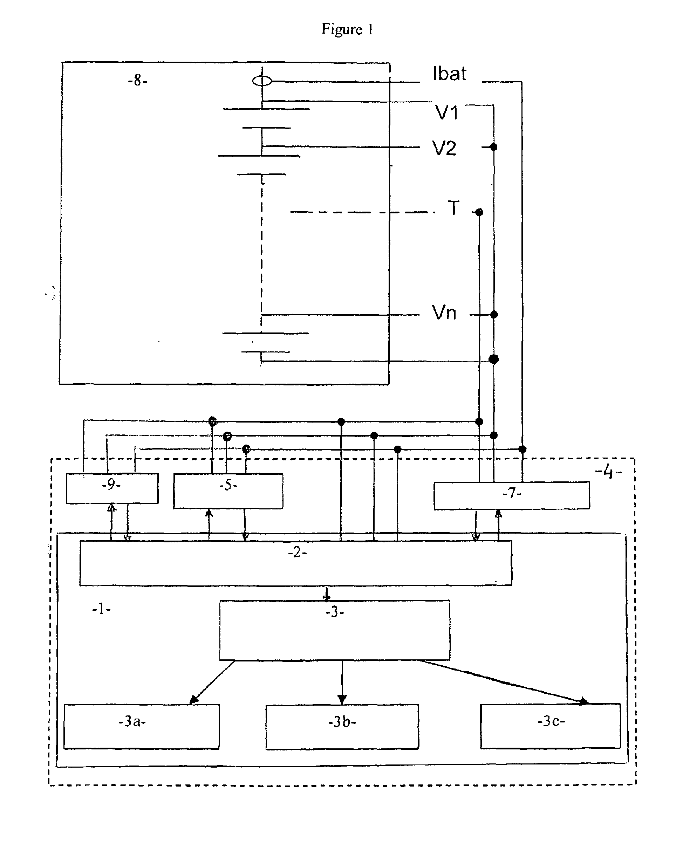

Le système de surveillance va être décrit en faisant référence à la figure 1, qui est un schéma explicatif du système de surveillance dans un exemple d'application. Une seule branche d'accumulateurs est représentée en figure 1. Cependant la batterie peut comprendre p branches parallèles, chaque branche parallèle comprenant n accumulateurs connectés en série.

Le système de surveillance 1 comprend des moyens de mesure de la tension V1, V2,..., Vn aux bornes de chaque accumulateur, des moyens de mesure de la température T de la batterie 8, et des moyens de mesure du courant Ibat traversant la batterie 8. Le système de surveillance 1 comprend également des moyens de calcul 2 d'une différence $\Delta V$ entre la tension maximale $V_{max}$ mesurée aux bornes d'un des accumulateurs et la tension minimale $V_{min}$ mesurée aux bornes d'un des accumulateurs. Le système de surveillance 1 comprend également des moyens de comparaison 3 de la différence $\Delta V$ avec au moins une valeur seuil $\Delta Vs$ dépendant de la température T et du courant Ibat mesurés; et des moyens 3a, 3b, 3c signalant une erreur si $\Delta V \geq \Delta Vs$.

Selon un mode de réalisation, la différence de tension $\Delta V$ est comparée à une première valeur seuil $\Delta Vs1$ donnée par l'expression

$$\Delta Vs1 = n \times R(T) \times \frac{Ibat}{p-1},$$

où p est le nombre de branches parallèles d'accumulateurs de la batterie et n est le nombre d'accumulateurs reliés en série dans chaque branche,
R(T) est la résistance en début de vie — en fonction de la température — des accumulateurs électrochimiques constituant la batterie, et
Ibat est le courant de charge ou décharge de la batterie.

La résistance R est fonction de la température et peut également être fonction du courant. La résistance R peut être une valeur moyenne des résistances début de vie des accumulateurs fournie par le constructeur dans une table attribuant une valeur de résistance en début de vie pour chaque couple température — courant (le cas échéant). Elle peut alternativement être obtenue en faisant la moyenne des résistances début de vie des accumulateurs de la batterie. Ainsi la valeur du seuil $\Delta Vs1$ dépend de la température T et du courant Ibat mesurés.

En particulier, la comparaison de la différence $\Delta V$ avec la valeur seuil $\Delta Vs1$ est effectuée lorsque la batterie est en fonctionnement, c'est-à-dire lorsque le courant Ibat est non nul. Différentes valeurs seuil $\Delta Vs1$ peuvent alors être définies suivant le courant requis par l'application reliée à la batterie, et selon les conditions de température de l'application.

Les moyens de signalisation d'erreur 3a du système de surveillance 1 signalent une erreur si $\Delta V \geq \Delta Vs1$. En effet une différence de tension $\Delta V$ entre la plus grande valeur de tension mesurée $V_{max}$ et la plus petite valeur de tension mesurée $V_{min}$ supérieure ou égale à la valeur seuil $\Delta Vs1$ indique la présence d'un accumulateur en circuit ouvert.

Ainsi, le système de surveillance pour batterie de l'invention permet de détecter la présence d'un accumulateur défaillant en circuit ouvert en mesurant la tension aux bornes de chaque accumulateur, en calculant la différence de tension $\Delta V$ entre la plus grande valeur de tension mesurée $V_{max}$ et la plus petite valeur de tension mesurée $V_{min}$, et en comparant la différence $\Delta V$ avec la valeur seuil $\Delta Vs1$. Un signal d'erreur peut alors être envoyé à un utilisateur ou vers d'autres systèmes électroniques.

Selon un mode de réalisation, la différence de tension $\Delta V$ est comparée à une deuxième valeur seuil $\Delta Vs2$ donnée par l'expression

$$\Delta Vs2 = \Delta R_{max}(T) \times \frac{Ibat}{p},$$

où p est le nombre de branches parallèles d'accumulateurs de la batterie, $\Delta R_{max}(T)$ est la dispersion maximale — en fonction de la température — tolérée entre les résistances internes des accumulateurs, et Ibat est le courant de charge ou décharge de la batterie.

La résistance de chaque accumulateur est fonction de la température et éventuellement du courant le traversant. $\Delta R_{max}$ dépend de la température et pourra être déterminée à partir des tables de résistances début de vie fournies par le constructeur des accumulateurs. Ainsi la valeur seuil $\Delta Vs2$ dépend du courant Ibat mesuré et de la température de la batterie. En particulier, la comparaison de la différence $\Delta V$ avec la valeur seuil $\Delta Vs2$ est effectuée lorsque la batterie est en fonctionnement, c'est-à-dire lorsque le courant Ibat est non nul.

Les moyens de signalisation d'erreur 3b du système de surveillance 1 signalent une erreur si $\Delta V \geq \Delta Vs2$. En effet une différence de tension $\Delta V$ entre la plus grande valeur de tension mesurée $V_{max}$ et la plus petite valeur de tension mesurée $V_{min}$ supérieure à la valeur seuil $\Delta Vs2$ indique une dispersion de résistance trop grande entre les accumulateurs de la batterie. Ainsi, la valeur seuil $\Delta Vs2$ est choisie comme la valeur maximale tolérée pour éviter un point chaud trop important. La valeur seuil $\Delta Vs2$ est déterminée en fonction de la température et du courant de la batterie. Par exemple, la valeur seuil $\Delta Vs2$ peut prendre une valeur correspondant à deux fois la résistance début de vie à 0°C multipliée par le courant batterie et divisée par le nombre de branches parallèles d'accumulateurs connectés en série.

Ainsi grâce à une mesure de tension, le système de surveillance 1 selon l'invention caractérise l'homogénéité des résistances des accumulateurs de la batterie sans surcoût au niveau des circuits électroniques. En effet, le calcul de la valeur seuil $\Delta Vs2$ demande moins de ressources de calcul qu'une estimation de la résistance de chaque accumulateur de la batterie. La dispersion entre les résistances internes des accumulateurs peut être due à un vieillissement inhomogène entre les accumulateurs de la batterie. La dispersion entre les résistances internes des accumulateurs peut être également due à un problème mécanique sur le circuit de puissance, tel qu'une vis de connexion desserrée.

Selon un mode de réalisation, la différence de tension $\Delta V$ est comparée à une troisième valeur seuil $\Delta Vs3$ ayant une valeur prédéterminée lorsque la batterie n'est pas en fonctionnement, c'est-à-dire lorsque le courant Ibat est nul, ou sensiblement nul. Cette troisième valeur seuil $\Delta Vs3$ est constante pour une température donnée, et est fixée à une valeur dépendant de la perte de capacité tolérée par un utilisateur avant de procéder au changement de la batterie. Par exemple pour une batterie d'accumulateurs lithium-ion, on pourra prendre une valeur seuil $\Delta Vs3$ de 100mV autorisant une perte de capacité de 10%.

Les moyens de signalisation d'erreur 3c du système de surveillance 1 signalent une erreur si $\Delta V \geq \Delta Vs3$.

Dans un mode de réalisation, les moyens signalant une erreur si $\Delta V \geq \Delta Vs$ sont désactivés lorsque la valeur absolue du courant Ibat mesuré sort d'une plage de valeurs seuils de courant prédéterminées. La plage de valeurs seuils de courant est spécifique à la valeur seuil $\Delta Vs$. Notamment, lorsque la valeur absolue du courant Ibat mesuré est inférieure à une valeur seuil Imin1, les moyens de signalisation d'erreur si $\Delta V \geq \Delta Vs1$ sont désactivés ; de même, lorsque la valeur absolue du courant Ibat mesuré est inférieure à un seuil Imin2, les moyens de signalisation d'erreur si $\Delta V \geq \Delta Vs2$ sont désactivés.

Comme décrit précédemment, les valeurs seuils $\Delta Vs1$ et $\Delta Vs2$ dépendent du courant Ibat de la batterie. Les seuils de courant Imin1 et Imin2 sont fixés à des valeurs suffisamment importantes pour que les valeurs seuils $\Delta Vs1$ et $\Delta Vs2$ soient suffisamment grandes par rapport à l'incertitude de mesure de la tension V d'un accumulateur. Par exemple, la mesure de la tension d'un accumulateur peut être précise à plus ou moins 20 mV, la différence de tension $\Delta V$ entre la plus grande valeur de tension mesurée $V_{max}$ et la plus petite valeur de tension mesurée $V_{min}$ est donc précise à plus ou moins 20 mV. En choisissant Imin1 et Imin2 de sorte que les seuils $\Delta Vs1$ et $\Delta Vs2$ soient toujours supérieurs à 100 mV, on limite le risque de fausses détections dues à une erreur de mesure sur la tension.

Également, lorsque la valeur absolue du courant Ibat de la batterie est supérieure à une valeur seuil Imax, les moyens de signalisation d'erreur si $\Delta V \geq \Delta Vs3$ sont désactivés. Autrement dit, la détection d'une perte de capacité importante est inhibée lorsque le courant Ibat est supérieur à la valeur seuil Imax. La valeur seuil Imax est déterminée en fonction de l'incertitude sur la mesure du courant pour de faibles valeurs de courant. Par exemple, si une valeur du courant Ibat de 0A peut être obtenue avec une incertitude de plus ou moins 2A, on peut choisir une valeur de 4A pour Imax.

Selon un mode de réalisation, le système de surveillance pour batterie peut comprendre en outre des moyens de mesure du courant Ibranche traversant chaque branche parallèle d'accumulateurs connectés en série. Le système de surveillance 1 comprend alors des moyens de comparaison du courant Ibranche pour chaque branche avec deux seuils SeuilI1 et SeuilI2. Les seuils de courant SeuilI1 et SeuilI2 dépendent de la précision des moyens de mesure du courant. Le système de surveillance 1 comprend également des moyens de signalisation d'erreur si au moins l'une des branches parallèles a un courant Ibranche la traversant inférieur à SeuilI1, alors qu'au moins l'une des branches parallèles a un courant Ibranche la traversant supérieure à SeuilI2.

Le système de surveillance de l'invention comprend une ou plusieurs valeurs seuil telles que les valeurs $\Delta Vs1$, $\Delta Vs2$, $\Delta Vs3$. Ainsi, le système de surveillance permet de détecter un SOF de la batterie. Autrement dit, le système de surveillance de l'invention permet de détecter une perte de capacité trop élevée, et/ou une dispersion élevée entre les résistances des accumulateurs, et/ou une défaillance en circuit ouvert d'un accumulateur à partir d'une mesure de tension ou de courant comparée à un critère dépendant de la température et du courant de la batterie.

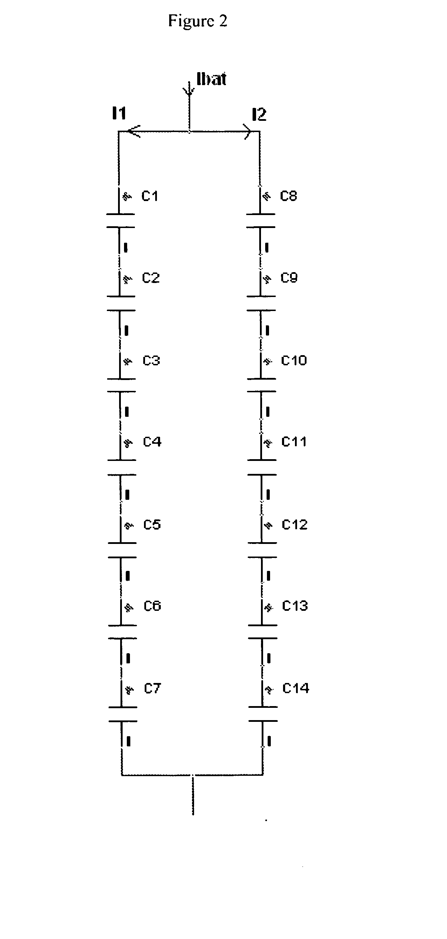

Le système se surveillance de l'invention sera mieux compris en prenant l'exemple d'une batterie de type 2P7S, c'est-à-dire une batterie présentant 2 branches parallèles chacune comprenant 7 accumulateurs en série telle que présentée en figure 2. La batterie 2P7S est composée d'accumulateurs C1-C14 référencés Saft VL30P chez la demanderesse.

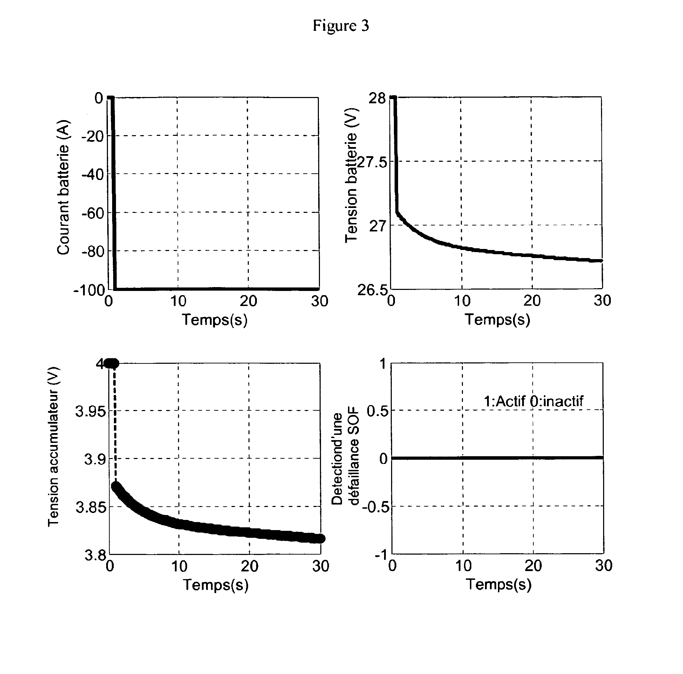

La figure 3 présente un fonctionnement sans défaillance de la batterie 8. De gauche à droite, et de haut en bas, la figure 3 montre l'évolution temporelle du courant Ibat traversant la batterie, de la tension aux bornes de la batterie, de la tension aux bornes des accumulateurs de la batterie, et du signal de détection d'erreur. Une valeur nulle du signal de détection d'erreur indique une absence de défaillance. Le signal de détection d'erreur prend la valeur 1 si une défaillance est détectée.

Quelques secondes après l'instant initial (t=0), la batterie est traversée d'un courant constant de valeur absolue 100A, et présente une tension à ses bornes décroissante. On observe que la tension aux bornes des accumulateurs est sensiblement la même (les courbes respectives des accumulateurs sont superposées). Par conséquent le signal de détection d'erreur est inactif.

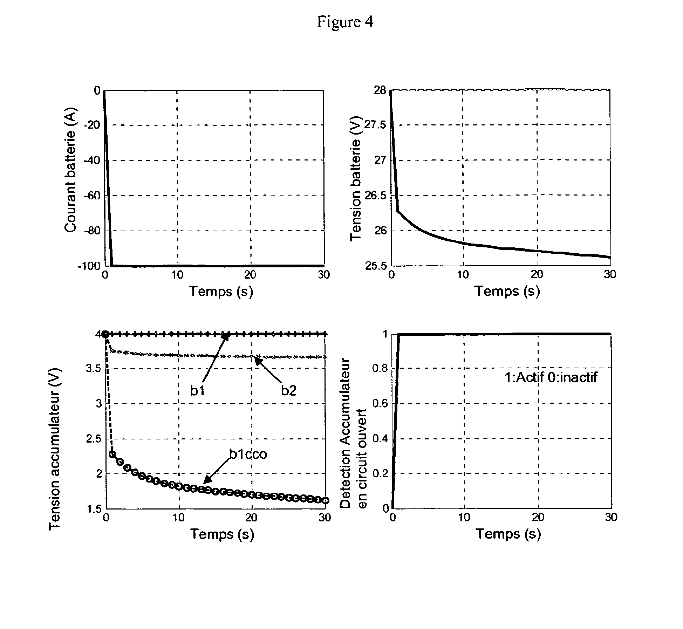

La figure 4 présente une détection d'un accumulateur en circuit ouvert dans la batterie 8. Les résultats présentés sont obtenus par simulation à une température de 0°C. Une première branche des branches parallèles de la batterie a un accumulateur en circuit ouvert ayant une tension qui présente une évolution temporelle suivant la courbe b1cco. Les accumulateurs non défaillants de la première branche parallèle ont une tension ayant une évolution temporelle suivant la courbe b1. Les accumulateurs de la deuxième branche parallèle de la batterie ont une tension ayant une évolution temporelle suivant la courbe b2.

Lorsqu'une première branche parallèle de la batterie 8 comprend un accumulateur en circuit ouvert, les accumulateurs situés sur la seconde branche parallèle vont être parcourus par la totalité du courant Ibat de la batterie 8. En supposant que tous les accumulateurs ont le même état de charge, chaque accumulateur de la seconde branche parallèle présente une tension V_acc à ses bornes, donnée par l'expression :

$$V\_acc = E_0 - R \times Ibat$$

où $E_0$ est la force électromotrice de l'accumulateur ;
R est la résistance de l'accumulateur qui dépend de la température de la batterie 8 et du courant traversant la branche contenant l'accumulateur.
La seconde branche parallèle présente donc une tension à ses bornes égale à 7x($E_0$-RxIbat).

Dans la première branche parallèle, les accumulateurs autres que l'accumulateur en circuit ouvert ont chacun à leurs bornes une tension égale à la force électromotrice $E_0$ de l'accumulateur, car ils ne sont parcourus par aucun courant. La loi des mailles imposant l'égalité des tensions entre les deux branches parallèles, la première branche parallèle a une tension de *7x($E_0$-RxIbat)*. La tension $V_{co}$ aux bornes de l'accumulateur en circuit ouvert est donc égale à

$$V_{CO} = E_0 - 7 \times R \times Ibat$$

Ainsi dans le cas où l'une des branches parallèles de la batterie 7 présente un accumulateur en circuit ouvert, la différence de tension ΔV entre la plus grande valeur de tension mesurée $V_{max}$ et la plus petite valeur de tension mesurée $V_{min}$ est égale à

$$\Delta V = E_0 - \left( E_0 - 7 \times R \times Ibat \right) = 7 \times R \times Ibat$$

Cette valeur peut définir la valeur seuil ΔVs1. La valeur seuil ΔVs1 peut également prendre une valeur inférieure à *7xRxIbat* afin d'augmenter la sensibilité de détection d'un évènement tel qu'un accumulateur en circuit ouvert. Par exemple, la valeur seuil ΔVs1 peut être égale à *6 × R × Ibat*. La résistance R peut être obtenue à partir d'une table donnant la résistance début de vie de l'accumulateur en fonction de la température et du courant. Une telle table est généralement établie à partir de tests électriques réalisés par le constructeur.

Une différence de tension ΔV supérieure ou égale à la valeur seuil ΔVs1 entraîne le passage du signal de détection d'erreur à la valeur 1, indiquant la présence d'un accumulateur en circuit ouvert.

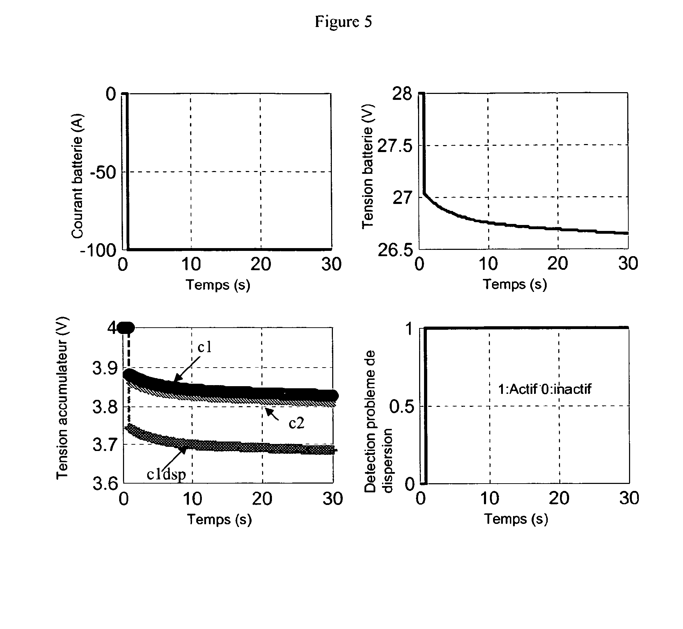

La figure 5 présente une détection d'une dispersion de résistance élevée entre les accumulateurs de la batterie.

Les résultats présentés sont obtenus par simulation à une température de 0°C. Une première branche des branches parallèles de la batterie a un accumulateur présentant une résistance supérieure de 3mΩ à celle des autres accumulateurs, et une tension ayant une évolution temporelle suivant la courbe c1dsp. Les accumulateurs non défaillants de la première branche parallèle ont une tension ayant une évolution temporelle suivant la courbe c1. Les accumulateurs de la deuxième branche parallèle de la batterie 2P7S ont une tension ayant une évolution temporelle suivant la courbe c2.

En fonctionnement (le courant Ibat est alors non nul) la différence de tension ΔV entre la plus grande valeur de tension mesurée $V_{max}$ et la plus petite valeur de tension mesurée $V_{min}$ est égale à

$$\Delta V = \left( E_{0i} - R_i \times \frac{Ibat}{2} \right) - \left( E_{0j} - R_j \times \frac{Ibat}{2} \right) = \Delta E_{0ij} + \Delta R_{ij} \times \frac{Ibat}{2}$$

où $V_{max}$ et $V_{min}$ sont respectivement mesurés sur les accumulateurs i et j,

$E_{0i}$, et $E_{0j}$ sont les forces électromotrices des accumulateurs i et j, et

$\Delta R_{ij}$ est la différence de résistance entre les accumulateurs i et j.

La différence $\Delta E_{0ij}$ entre les forces électromotrices des accumulateurs i et j est sensiblement nulle en supposant que les accumulateurs de la batterie ne présentent pas de différence d'état de charge.

La différence de résistance $\Delta R_{ij}$ entre les accumulateurs i et j doit être inférieure à la dispersion maximale $\Delta R_{max}$ tolérée pour éviter un point chaud trop important. Cette dispersion maximale $\Delta R_{max}$ est déterminée à partir des tables de résistance des accumulateurs fournies par le constructeur ; elle dépend donc de la température et du courant.

Ainsi on peut choisir la valeur seuil ΔVs2 telle que

$$\Delta Vs2 = \Delta R_{max}(T) \times \frac{Ibat}{2}.$$

Ainsi, la valeur seuil ΔVs2 est fonction du courant Ibat et de la température de la batterie. Dans l'exemple présenté en figure 5, la dispersion maximale $\Delta R_{max}$ a une valeur de 2mΩ pour une température de 0°C. La valeur seuil ΔVs2 peut donc prendre la valeur Ibat. $10^{-3}$. Une différence de tension ΔV supérieure ou égale à la valeur seuil ΔVs2 entraîne le passage du signal de détection d'erreur à la valeur 1, indiquant une dispersion de résistance trop grande entre les accumulateurs de la batterie.

Selon un mode de réalisation, la détection d'une défaillance en circuit ouvert d'un accumulateur peut aussi être réalisée à partir de mesures du courant réalisées sur chaque branche parallèle de l'accumulateur. Dans le cas d'une batterie 2P7S il y aurait donc deux moyens de mesure du courant. Ainsi, lorsqu'une première branche parallèle de la batterie 8 comprend au moins un accumulateur en circuit ouvert, les accumulateurs situés sur la seconde branche parallèle sont parcourus par la totalité du courant Ibat lors du fonctionnement de la batterie 8 (courant Ibat non nul). Le courant I1 mesuré sur la première branche parallèle et le courant I2 mesuré sur la seconde branche parallèle ont donc respectivement pour valeur 0 et Ibat.

Par exemple des valeurs de seuils Seuil1 et Seuil2 peuvent être fixés respectivement à 4A et 20A. Ainsi si une première branche parallèle présente un courant inférieur à 4A et la deuxième branche présente un courant supérieur à 20A, la présence d'au moins un accumulateur en circuit ouvert sur la première branche parallèle est détectée. Un signal d'erreur peut alors être envoyé à un utilisateur ou vers d'autres systèmes électroniques

L'invention concerne également un système de supervision 4 pour batterie comprenant le système de surveillance selon l'invention décrit précédemment.

Dans un mode de réalisation, le système de supervision 4 peut en outre comprendre un moyen de détermination de l'état de santé SOH 9 de la batterie 8. Le SOH peut être déterminé de manière dynamique au niveau module, ou batterie. Alternativement, le SOH peut être déterminé à partir d'un modèle prédictif du vieillissement des accumulateurs. La détermination du SOH est ainsi moins coûteuse en temps de calcul et en ressources électroniques par rapport à une détermination du SOH en temps réel (c'est-à-dire une détermination dynamique).

En particulier dans ce mode de réalisation, la mesure de la différence de tension ΔV, et sa comparaison avec les valeurs seuils ΔVs1 et ΔVs2 permet d'estimer l'homogénéité de la résistance des accumulateurs de la batterie 8. Ainsi, le système de supervision 4 pour batterie utilisant un modèle prédictif du SOH et comprenant le système de surveillance 1 selon l'invention permet de vérifier si l'hypothèse d'un vieillissement homogène entre les accumulateurs de la batterie 8 reste valable pour la détermination du SOH à partir du modèle prédictif.

Le modèle prédictif de détermination du SOH est invalidé si la différence de tension ΔV est supérieure ou égale à la première valeur seuil ΔVs1, ce qui correspond au cas où l'un des accumulateurs a une défaillance assimilable à un circuit ouvert.

Le modèle prédictif de détermination du SOH est également invalidé si la différence de tension ΔV est supérieure à la seconde valeur seuil ΔVs2, ce qui correspond au cas où la dispersion de la résistance entre les accumulateurs est trop élevée. Une dispersion de la résistance trop élevée peut être due à un vieillissement inhomogène des accumulateurs de la batterie 8 ou à un problème mécanique dans le circuit de puissance, tel qu'une vis de connexion desserrée. Dans ce cas, la tension de batterie minimale utilisable par un utilisateur n'est pas garantie.

Par ailleurs, le système de supervision 4 pour batterie selon l'invention peut en outre comprendre un moyen de détermination de l'état de charge SOC 5 de la batterie 8. Le SOC de la batterie 8 peut être déterminé à partir de mesures de tension et de courant de la batterie 8, éventuellement avec l'aide d'un modèle. Lors de la mise à jour sous tension du SOC de la batterie 8 (phase de recalage), l'erreur sur la valeur du SOC est proportionnelle à la résistance maximale des accumulateurs de la batterie 8 multipliée par le courant maximum toléré pour cette phase de mise à jour. Le système de supervision 4, grâce au système de surveillance 1 selon l'invention, à partir de la différence de tension ΔV, vérifie que les résistances internes des accumulateurs de la batterie 8 ne présentent pas une dispersion trop importante qui diminuerait la précision sur la valeur du SOC.

Dans ce mode de réalisation, le système de supervision 4 peut comprendre des moyens de détermination du SOC de chaque accumulateur de la batterie, et des moyens de détermination de la dispersion d'état de charge des accumulateurs. Ladite au moins une valeur seuil ΔVs est alors corrigée si la dispersion d'état de charge est supérieure à une valeur prédéterminée. Autrement dit, le système de supervision 4 peut comprendre des moyens de correction des valeurs seuil ΔVs en fonction de la dispersion de l'état de charge entre les accumulateurs de la batterie. La valeur de la dispersion d'état de charge entre les accumulateurs peut être fournie par un algorithme déterminant le SOC de chaque accumulateur. Alors, la dispersion de l'état de charge acceptable entre les accumulateurs peut être ajoutée aux valeurs seuil ΔVs1 et ΔVs2. Par exemple, si la différence d'état de charge maximale entre deux éléments de la batterie est de 2%, on ajoutera 20 mV aux valeurs seuil ΔVs1 et ΔVs2.

Par ailleurs, le système de supervision 4 pour batterie 8 selon l'invention peut en outre comprendre un système d'équilibrage 7 de la charge des accumulateurs de la batterie 8. L'erreur sur l'équilibrage de la batterie 8 est proportionnelle à la dispersion maximale sur la résistance $\Delta R_{max}$ multipliée par le courant maximum toléré pour cette phase d'équilibrage. Le système de supervision 4, grâce au système de surveillance 1 selon l'invention, à partir de la différence de tension ΔV, vérifie que les accumulateurs de la batterie 8 ne présentent pas une dispersion de résistance trop importante qui diminuerait la fiabilité sur l'équilibrage de charge des accumulateurs de la batterie 8.

En particulier dans ce mode de réalisation, le système de supervision 4, grâce au système de surveillance 1 selon l'invention, peut comparer la différence ΔV avec la valeur seuil ΔVs3 afin de vérifier que les accumulateurs de la batterie 8 ne présentent pas une perte de capacité trop élevée. Une perte de capacité trop élevée invaliderait l'équilibrage entre les accumulateurs de la batterie 8, et provoquerait une perte d'énergie pour un utilisateur et un risque de tension trop importante de certains accumulateurs.

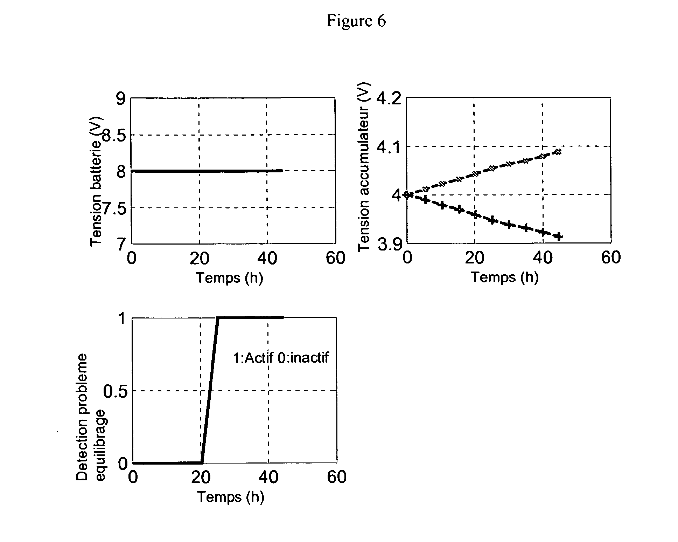

La figure 6 montre les résultats obtenus par simulation sur une batterie composée de deux accumulateurs Saft VL30P connectés en série et alimentés par une tension constante égale à 8V. L'un des accumulateurs présente un fort courant d'autodécharge qui conduit à une forte divergence des tensions aux bornes des deux accumulateurs. Avec une valeur seuil ΔVs3 fixée à 100 mV, le système de surveillance signale une défaillance du système d'équilibrage au système de supervision de la batterie.

Dans un mode de réalisation du système de supervision 4 pour batterie, les moyens de signalisation d'erreur du système de surveillance 1 permettent de prévenir un utilisateur. Ainsi un utilisateur de la batterie 8 peut connaître la validité des valeurs de SOH, et/ou de SOC, et/ou de l'équilibrage des charges entre les accumulateurs.

Le système de supervision 4 de l'invention peut combiner différemment les divers modes de réalisation présentés ci-dessus. Par exemple, le système de supervision peut comprendre un système de surveillance selon l'invention, un moyen de détermination du SOC et un système d'équilibrage de la charge (sans détermination du SOH). Dans ce cas la valeur seuil ΔVs2 peut être choisie comme la valeur maximale tolérée pour éviter une erreur trop importante sur l'algorithme de SOC lorsque celui-ci provient des mesures de tension, et une erreur trop importante sur l'algorithme d'équilibrage. Dans ce cas la valeur seuil ΔVs1 pourrait également être omise. De même, on pourrait envisager un système de supervision comprenant un système de surveillance selon l'invention, un moyen de détermination du SOC et un moyen de détermination du SOH (sans système d'équilibrage de la charge). Dans ce cas la valeur seuil ΔVs3 pourrait être omise. Bien entendu, le système de supervision peut comprendre un système de surveillance selon l'invention, un moyen de détermination du SOC, un moyen de détermination du SOH et un système d'équilibrage de la charge.

Grâce à des mesures de tension, de courant, et de température, le système de supervision 4 selon l'invention comprenant le système de surveillance 1 vérifie la dispersion sur la résistance entre les accumulateurs, et l'absence de défaillance dans le circuit de puissance de la batterie 8. Le système de supervision 4 peut alors déterminer la validité de caractéristiques de la batterie 8, telles que le SOH, le SOC, et l'équilibrage des accumulateurs de la batterie 8.

Bien entendu, la présente invention n'est pas limitée aux modes de réalisation précédemment décrits à titre d'exemple. Le système de surveillance 1 selon l'invention a été présenté pour une batterie 8 de type 2P7S. Cependant, le nombre de branches reliées en parallèle peut varier, ainsi que le nombre d'accumulateurs reliés en série dans une branche.

**Revendications**

1. Système de surveillance (1) pour batterie ayant une pluralité d'accumulateurs, le système comprenant :

   - des moyens de mesure de la tension (V1, V2, Vn) aux bornes de chaque accumulateur ;
   - des moyens de mesure de la température (T) de la batterie ;
   - des moyens de mesure du courant traversant la batterie (Ibat) ;
   - des moyens de calcul (2) d'une différence de tension ($\Delta V$) entre une tension maximale ($V_{max}$) mesurée aux bornes d'un des accumulateurs et une tension minimale ($V_{min}$) mesurée aux bornes d'un des accumulateurs ;
   - des moyens de comparaison (3) de la différence de tension ($\Delta V$) avec au moins une valeur seuil ($\Delta Vs$); et
   - des moyens (3a, 3b, 3c) signalant une erreur si la différence de tension ($\Delta V$) est supérieure ou égale à l'au moins une valeur seuil ($\Delta Vs$) ; **caractérisé en ce que** ladite au moins une valeur seuil ($\Delta Vs$) est calculée en fonction de la température (T) et du courant (Ibat) mesurés.

2. Système de surveillance (1) selon la revendication 1, dans lequel au moins l'un des moyens de signalisation d'erreur (3a, 3b, 3c) est désactivé si la valeur absolue du courant (Ibat) mesuré sort d'une plage de valeurs seuils de courant, la plage de valeurs étant spécifique à la valeur seuil ($\Delta Vs$).

3. Système de surveillance (1) selon l'une des revendications précédentes,
   dans lequel la différence de tension ($\Delta V$) est comparée à une valeur seuil ($\Delta Vs1$) définie comme

$$\Delta Vs1(T, Ibat) = n \times R(T) \times \frac{Ibat}{p-1},$$

   où p est le nombre de branches parallèles d'accumulateurs de la batterie, avec $p \geq 2$, et n est le nombre d'accumulateurs reliés en série dans chaque branche, R(T) est la résistance en début de vie des accumulateurs électrochimiques constituant la batterie, qui dépend de la température, et
   Ibat est le courant traversant la batterie.

4. Système de surveillance (1) selon l'une des revendications précédentes, dans lequel la différence de tension ($\Delta V$) est comparée à une valeur seuil ($\Delta Vs2$) définie comme

$$\Delta Vs2(T, Ibat) = \Delta R_{max}(T) \times \frac{Ibat}{p},$$

   où p est le nombre de branches parallèles d'accumulateurs de la batterie, $\Delta R_{max}(T)$ est la dispersion maximale tolérée entre les résistances internes des accumulateurs, qui dépend de la température, et
   Ibat est le courant traversant la batterie.

5. Système de surveillance (1) selon l'une des revendications précédentes, pour une batterie ayant des accumulateurs assemblés en une pluralité de branches parallèles, le système comprenant en outre :

   - des moyens de mesure du courant (Ibranche) traversant chaque branche de la batterie;
   - des moyens de comparaison du courant (Ibranche) de chaque branche avec un premier seuil (Seuil1) et avec un deuxième seuil (Seuil2) ;
   - des moyens signalant une erreur si pour une des branches de la batterie le courant (Ibranche) mesuré est inférieur ou égal au premier seuil (Seuil1) et si pour une autre des branches de la batterie le courant (Ibranche) mesuré est supérieur ou égal au deuxième seuil (Seuil2).

**6.** Système de surveillance (1) selon l'une des revendications 1 à 2, dans lequel la différence de tension (ΔV) est comparée à une valeur seuil (ΔVs3) prédéterminée lorsque le courant de la batterie (Ibat) est sensiblement nul.

**7.** Système de supervision (4) pour batterie comprenant :

- un système de surveillance selon l'une des revendications 1 à 5, et
- un moyen de détermination de l'état de charge (SOC) (5) de la batterie.

**8.** Système de supervision (4) pour batterie selon la revendication 7 comprenant :

- des moyens de détermination de l'état de charge (SOC) de chaque accumulateur de la batterie,
- des moyens de détermination de la dispersion d'état de charge des accumulateurs,

dans lequel ladite au moins une valeur seuil (ΔVs) est corrigée si la dispersion d'état de charge est supérieure à une valeur prédéterminée.

**9.** Système de supervision (4) pour batterie comprenant :

- un système de surveillance selon l'une des revendications 1 à 5,
- un moyen de détermination de l'état de santé (SOH) (9) de la batterie à partir d'un modèle prédictif,

dans lequel si la différence de tension (ΔV) est supérieure à au moins une valeur seuil (ΔVs), les moyens de signalisation d'erreur indiquent que le modèle prédictif de détermination du SOH est invalide.

**10.** Système de supervision (4) pour batterie comprenant :

- un système de surveillance selon la revendication 6, et
- un système d'équilibrage (7) de la charge des accumulateurs de la batterie.

**11.** Système de supervision (4) pour batterie selon l'une des revendications 7 à 10 dans lequel les moyens de signalisation d'erreur (3a, 3b, 3c) du système de surveillance (1) permettent de prévenir un utilisateur.

**Claims**

**1.** A monitoring system (1) for a battery having a plurality of accumulators, the system comprising:

- means for measuring the voltage (V1, V2, Vn) on the terminals of each accumulator;
- means for measuring the temperature (T) of the battery;
- means for measuring the current flowing through the battery (Ibat);
- means (2) for calculating a voltage difference (ΔV) between a maximum voltage ($V_{max}$) measured on the terminals of one of the accumulators and a minimum voltage ($V_{min}$) measured on the terminals of one of the accumulators;
- means (3) for comparing the voltage difference (ΔV) with at least one threshold value (ΔVs); and
- means (3a, 3b, 3c) reporting an error if the voltage difference (ΔV) is greater than or equal to said at least one threshold value (ΔVs), **characterized in that** said at least one threshold value (ΔVs) is calculated as a function of the measured temperature and current (Ibat).

**2.** The monitoring system (1) according to claim 1, wherein at least one of the error reporting means (3a, 3b, 3c) is disabled if the absolute value of the measured current (Ibat) leaves a range of current threshold values, the range of values being specific to the threshold value (ΔVs).

**3.** The monitoring system (1) according to one of the preceding claims, wherein the voltage difference (ΔV) is compared with a threshold value (ΔVs1) defined as

$$\Delta Vs1(T, Ibat) = n \times R(T) \times \frac{Ibat}{p-1}$$

wherein p is the number of parallel branches of accumulators of the battery, with $p \geq 2$, and n is the number of accumulators connected in series in each branch,
R(T) is the resistance at the beginning of the life of the electrochemical accumulators forming the battery, which depends on the temperature, and Ibat is the current flowing through the battery.

4. The monitoring system (1) according to one of the preceding claims,
wherein the voltage difference ($\Delta V$) is compared with a threshold value ($\Delta Vs2$) defined as

$$\Delta Vs2(T, Ibat) = \Delta R_{max}(T) \times \frac{Ibat}{p}$$

wherein p is the number of parallel branches of accumulators of the battery, $\Delta R_{max}(T)$ is the maximum tolerated spread among the internal resistances of the accumulators, which depends on the temperature, and
Ibat is the current flowing through the battery.

5. The monitoring system (1) according to one of the preceding claims, for a battery having accumulators assembled in a plurality of parallel branches, the system further comprising:

   - means for measuring the current (Ibranch) flowing through each branch of the battery;
   - means for comparing the current (Ibranch) of each branch with a first threshold (Seuill1) and with a second threshold (Seuill2);
   - means reporting an error if for one of the branches of the battery, the measured current (Ibranch) is less than or equal to the first threshold (Seuill1) and if for another of the branches of the battery, the measured current (Ibranch) is greater than or equal to the second threshold (Seuill2).

6. The monitoring system (1) according to one of claims 1 to 2, wherein the voltage difference ($\Delta V$) is compared with a predetermined threshold value ($\Delta Vs3$) when the current of the battery (Ibat) is substantially zero.

7. A supervision system (4) for a battery comprising:

   - a monitoring system according to one of claims 1 to 5, and
   - a means for determining the state of charge (SOC) (5) of the battery.

8. The supervision system (4) for a battery according to claim 7 comprising:

   - means for determining the state of charge (SOC) of each accumulator of the battery,
   - means for determining the spread of the state of charge of the accumulators, wherein said at least one threshold value ($\Delta Vs$) is corrected if the spread of the state of charge is greater than a predetermined value.

9. The supervision system (4) for a battery comprising:

   - a monitoring system according to one of claims 1 to 5,
   - a means for determining the state of health (SOH) (9) of the battery from a predictive model,
   wherein if the voltage difference ($\Delta V$) is greater than at least one threshold value ($\Delta Vs$), the error reporting means indicate that the predictive model for determining the SOH is invalid.

10. The supervision system (4) for a battery comprising:

   - a monitoring system according to claim 6, and
   - a system (7) for balancing the charge of the accumulators of the battery.

**11.** The supervision system (4) for a battery according to one of claims 7 to 10, wherein the error reporting means (3a, 3b, 3c) of the monitoring system (1) give the possibility of warning a user.

**Patentansprüche**

**1.** Überwachungssystem (1) für Batterien, die mehrere Akkumulatoren aufweisen, wobei das System Folgendes umfasst:

- Mittel zum Messen der Spannung (V1, V2, Vn) an den Klemmen von jedem Akkumulator;
- Mittel zum Messen der Temperatur (T) der Batterie;
- Mittel zur Messung des Stroms (Ibat), der die Batterie durchfließt;
- Mittel (2) zur Berechnung einer Spannungsdifferenz ($\Delta V$) zwischen einer an den Klemmen von einem der Akkumulatoren gemessenen Höchstspannung ($V_{max}$) und einer an den Klemmen von einem der Akkumulatoren gemessenen Mindestspannung ($V_{min}$);
- Mittel (3) zum Vergleich der Spannungsdifferenz ($\Delta V$) mit mindestens einem Schwellenwert ($\Delta Vs$); und
- Mittel (3a, 3b, 3c), die einen Fehler melden, wenn die Spannungsdifferenz ($\Delta V$) größer oder gleich mindestens einem Schwellenwert ($\Delta Vs$) ist; **dadurch gekennzeichnet, dass** der mindestens eine Schwellenwert ($\Delta Vs$) in Abhängigkeit von der gemessenen Temperatur (T) und dem gemessenen Strom (Ibat) berechnet wird.

**2.** Überwachungssystem (1) nach Anspruch 1, wobei mindestens eines der Fehlermeldungsmittel (3a, 3b, 3c) deaktiviert wird, wenn der Absolutwert des gemessenen Stroms (Ibat) einen Bereich von Stromschwellenwerten verlässt, wobei der Wertebereich für den Schwellenwert ($\Delta Vs$) spezifisch ist.

**3.** Überwachungssystem (1) nach einem der vorhergehenden Ansprüche, wobei die Spannungsdifferenz ($\Delta V$) mit einem Schwellenwert ($\Delta Vs1$) verglichen wird, der wie folgt definiert ist:

$$\Delta Vs1(T, Ibat) = n \; x \; R(T) x \; \frac{Ibat}{p-1},$$

wo p die Anzahl der parallelen Akkumulatorzweige der Batterie ist, wobei $p \geq 2$ und n die Anzahl der Akkumulatoren ist, die in jedem Zweig in Reihe geschaltet sind, R(T) der Widerstand zu Beginn der Lebensdauer der elektrochemischen Akkumulatoren ist, die die Batterie bilden, der von der Temperatur abhängt, und Ibat der Strom ist, der die Batterie durchfließt.

**4.** Überwachungssystem (1) nach einem der vorhergehenden Ansprüche, wobei die Spannungsdifferenz ($\Delta V$) mit einem Schwellenwert ($\Delta Vs2$) verglichen wird, der wie folgt definiert ist:

$$\Delta Vs2(T, Ibat) = \Delta \; R_{max}(T) x \; \frac{Ibat}{p},$$

wo p die Anzahl der parallelen Akkumulatorzweige der Batterie ist, $\Delta R_{max}(T)$ die maximale Streuung ist, die zwischen den Innenwiderständen der Akkumulatoren zulässig ist, die von der Temperatur abhängt, und Ibat der Strom ist, der die Batterie durchfließt.

**5.** Überwachungssystem (1) nach einem der vorhergehenden Ansprüche für eine Batterie, die Akkumulatoren aufweist, die in mehreren parallelen Zweigen zusammengebaut sind, wobei das System ferner Folgendes umfasst:

- Mittel zur Messung des Stroms (Ibranche), der jeden Zweig der Batterie durchfließt;
- Mittel zum Vergleich des Stroms (Ibranche) von jedem Zweig mit einem ersten Schwellenwert (Seuil1) und mit einem zweiten Schwellenwert (Seuil2);
- Mittel, die einen Fehler melden, wenn für einen der Zweige der Batterie der gemessene Strom (Ibranche) kleiner oder gleich dem ersten Schwellenwert (Seuil1) ist und wenn für einen anderen der Zweige der Batterie der gemessene Strom (Ibranche) größer oder gleich dem zweiten Schwellenwert (Seuill2) ist.

6. Überwachungssystem (1) nach einem der Ansprüche 1 bis 2, wobei die Spannungsdifferenz ($\Delta$V) mit einem Schwellenwert ($\Delta$Vs3) verglichen wird, der vorbestimmt ist, wenn der Strom der Batterie (Ibat) im Wesentlichen Null ist.

7. Kontrollsystem (4) für Batterien, das Folgendes umfasst:

   - ein Überwachungssystem nach einem der Ansprüche 1 bis 5, und
   - ein Mittel (5) zur Bestimmung des Ladezustands (SOC) der Batterie.

8. Kontrollsystem (4) für Batterien nach Anspruch 7, das Folgendes umfasst:

   - Mittel zur Bestimmung des Ladezustands (SOC) von jedem Akkumulator der Batterie,
   - Mittel zur Bestimmung der Streuung des Ladezustands der Akkumulatoren,

   wobei der mindestens eine Schwellenwert ($\Delta$Vs) korrigiert wird, wenn die Streuung des Ladezustands größer ist als ein vorbestimmter Wert.

9. Kontrollsystem (4) für Batterien, das Folgendes umfasst:

   - ein Überwachungssystem nach einem der Ansprüche 1 bis 5,
   - ein Mittel (9) zur Bestimmung des Gesundheitszustands (SOH) der Batterie ausgehend von einem prädiktiven Modell,

   wobei, wenn die Spannungsdifferenz ($\Delta$V) größer ist als mindestens ein Schwellenwert ($\Delta$Vs), die Fehlermeldungsmittel anzeigen, dass das prädiktive Modell zur Bestimmung des SOH ungültig ist.

10. Kontrollsystem (4) für Batterien, das Folgendes umfasst:

   - ein Überwachungssystem nach Anspruch 6, und
   - ein System (7) zum Ausgleich der Ladung der Akkumulatoren der Batterie.

11. Kontrollsystem (4) für Batterien nach einem der Ansprüche 7 bis 10, wobei die Fehlermeldungsmittel (3a, 3b, 3c) des Überwachungssystems (1) die Warnung eines Benutzers ermöglichen.

Figure 1

Figure 2

Figure 3

Figure 4

Figure 5

Figure 6

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7315789 A
- JP 2000150002 A
- JP 2002334726 A
- JP 2003257504 A
- JP 2009037962 B
- US 5675258 A